# EUROPEAN PATENT APPLICATION

(11) **EP 1 120 991 A2**
(43) Date of publication of application: **01.08.2001**
(21) Application number: 01300537.6
(22) Date of filing: 22.01.2001
(51) Int. Cl.: H04R 1/02

(54) **Electroacoustic transducer and attachment structure thereof**

(30) Priority: 26.01.2000 JP 2000017550
(71) Applicant: STAR MICRONICS CO., LTD., Shizuoka-shi, Shizuoka (JP)
(72) Inventor: Masuda, Mitsuhiro, Shizuoka-shi, Shizuoka (JP); Sone, Takahiro, Shizuoka-shi, Shizuoka (JP)
(74) Representative: Skone James, Robert Edmund

(57) **Abstract**

An electroacoustic transducer 1 has: a base 24 made of magnetic material; a magnetic core 22 provided erectly on the base 24; a diaphragm 20 supported so as to separate from a forward end of the magnetic core with an air gap therebetween; a magnet 25 constituting a magnetic circuit together with the base 24, the magnetic core 22 and the diaphragm 20 so as to apply a magnetostatic field to the magnetic circuit; a coil 23 for applying an oscillating magnetic field to the magnetic circuit; and a support ring 26 for supporting the diaphragm 20; wherein all the members constituting the electroacoustic transducer are enclosed in the base 24 and a casing 10; tapered coil spring terminals 40 are fixed to a wiring board 30 attached to the bottom surface of the base 24; and a skirt portion 13 of the casing 10 abuts against a circuit board 51 in the condition that the electroacoustic transducer 1 is mounted on the circuit board 51, so that the spring terminals 40 are prevented from being compressed beyond necessity.

## Description

The present invention relates to an electroacoustic transducer for generating sound by electromagnetic acoustic conversion, and a method for manufacturing such an electroacoustic transducer.

An electroacoustic transducer has a magnetic circuit in which a magnetic field from a magnet passes through a base member, a magnetic core and a diaphragm and returns the magnet again. When an electric oscillating signal is supplied to a coil wound around the magnetic core, an oscillating magnetic field generated by the coil is superimposed on the magnetostatic field of the magnetic circuit so that oscillation generated in the diaphragm is transmitted to the air, to thereby generate sound.

The electroacoustic transducer is provided with terminals for supplying a current to a coil, and the terminals are often connected to a wiring pattern of a circuit board by soldering or the like in the same manner as other electronic parts.

A method for making an electric connection by mechanical pressure contact between a spring terminal and a circuit board has come into wide use recently. Because soldering is not required, this method has advantages such as relaxation of parts heat-resistance, omission of a soldering step or a pre-treatment step thereof, and so on.

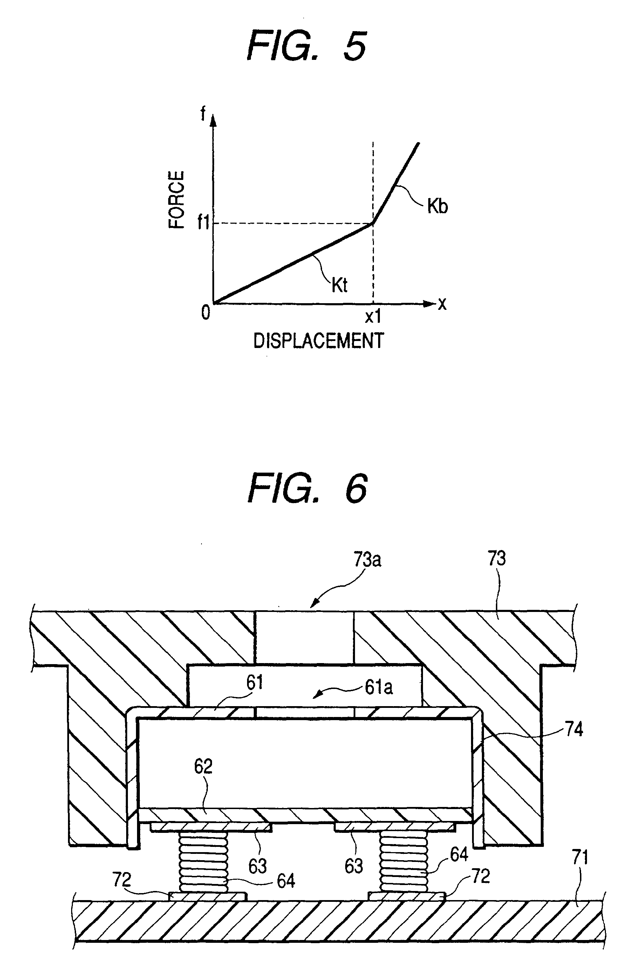

Fig. 6 is a partially sectional view showing an example of an attachment structure of a conventional electroacoustic transducer. The electroacoustic transducer is configured so that a magnetic circuit (not shown) constituted by a magnetic core, a coil, a magnet, a diaphragm, etc., is accommodated in a lower housing 62, and an upper housing 61 is coupled thereto. A pair of electrodes 63 for applying electric power to the coil is provided on the bottom surface of the lower housing 62, and cylindrical spring terminals 64 are disposed on the electrodes 63, respectively. Connection lands 72 are formed on a circuit board 71 correspondingly to the locations of the spring terminals 64 respectively.

A receiving portion 74 for receiving the electroacoustic transducer is formed inside a cover case 73 of an electronic apparatus. The upper housing 61 is substantially fitted with the receiving portion 74 so as to be positioned in the horizontal and height directions. A sound release aperture 73a is formed in the cover case 73 correspondingly to the position of a sound release hole 61a of the upper housing 61 so that sound generated by the electroacoustic transducer is released to the outside through the sound release hole 61a and the sound release aperture 73a.

In a step for assembling the electronic apparatus, when the cover case 73 receiving the electroacoustic transducer in advance is attached, the spring terminals 64 are brought into pressure contact with the connection lands 72 so that electric connection is ensured between the spring terminals 64 and the connection lands 72.

In such a mounting step based on spring pressure contact, a variation in contact pressure between the spring terminal 64 and the connection land 72 may cause a variation in circuit property or a failure in connection. As measures against such a variation in contact pressure, it is necessary to select the stroke and spring modulus of the spring terminal 64 properly to always keep the contact pressure not smaller than a fixed value.

If the stroke of the spring terminal 64 is elongated, the spring is also elongated as a whole. Accordingly, the height increases when the electroacoustic transducer is mounted. In addition, in the condition that the spring has been compressed to its limit, the spring cannot absorb displacement in the direction in which the spring is further compressed. As a result, the variation in contact pressure may increase or excessive stress may be applied to the cover case 73 or the circuit board 71 so as to affect the reliability of the electronic apparatus adversely.

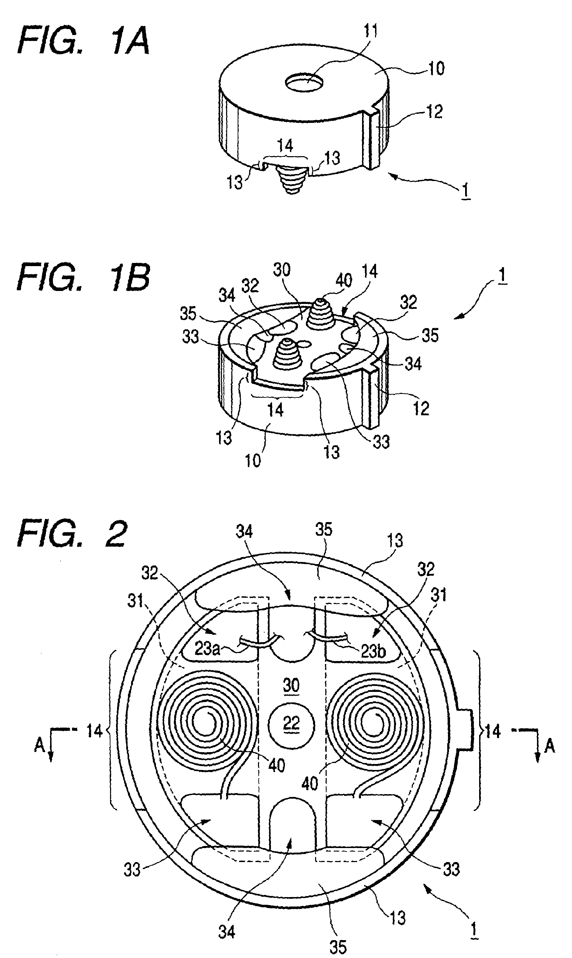

As a related art, JP-A-8-321670 discloses an electromagnetic sounder having electrode terminals like plate springs. However, in the configuration of Fig. 6 in which the electrode terminals are placed on the bottom surface of a main body, the height increases at the time of mounting as described above. On the other hand, in the configuration of Fig. 2 in which the electrode terminals are placed outside the main body to make parts thinner, the mounting area of the parts increases.

It is an object of the present invention to provide an electroacoustic transducer which can be reduced in thickness and size when it is mounted on an external circuit board, and to provide an attachment structure of the electroacoustic transducer which improves the reliability of spring mounting.

According to the present invention, there is provided an electroacoustic transducer comprising: a diaphragm made of magnetic material; an electromagnetic coil for applying an oscillating magnetic field to the diaphragm; a housing member for containing the diaphragm and the electromagnetic coil; tapered coil spring terminals provided on a bottom surface of the housing member so as to abut against an external circuit board for obtaining electric connections therewith, respectively; and a compression quantity limiting member provided on the housing member so as to abut against the external circuit board for limiting a compression quantity of the spring terminals.

According to the present invention, spring terminals which are to abut against an external circuit board are shaped in the form of tapered coils so that the forward ends of the tapered coils enter the insides of the tapered coils in the condition that the spring terminals are compressed, respectively. Accordingly, the length of each of the springs when the springs are compressed is shorter than that of a conventional cylindrical coil spring, so that a large spring stroke can be attained. As a result, the height at the time of mounting can be reduced, and the contact pressure between the spring terminals and the external circuit board can be stabilized.

In addition, a compression quantity limiting member is provided so as to abut against the external circuit board. When the spring terminals are compressed by a predetermined quantity, the spring terminals can absorb displacement in the direction in which the spring terminals are further compressed by the provision of the compression quantity limiting member, even in the condition that the electroacoustic transducer has been mounted on the external circuit board. Thus, the contact pressure can be prevented from varying.

Further, according to the present invention, a communication passageway for opening a space at a rear of the diaphragm is formed in the bottom surface of the housing member.

According to the present invention, a fixed space can be ensured by the external circuit board, the bottom of the housing member and the compression quantity limiting member in the condition that the electroacoustic transducer has been mounted on the external circuit board. Accordingly, the volume of the space at the rear of the diaphragm is substantially increased by making the fixed bottom-side space communicate with the rear-side space of the diaphragm. Thus, the air damper effect can be reduced so that the acoustic properties are improved.

In addition, according to the present invention, electric connection portions are disposed on the bottom surface of the housing member for soldering the spring terminals and lead wires of the electromagnetic coil, respectively.

According to the present invention, a fixed space can be ensured by the external circuit board, the bottom of the housing member and the compression quantity limiting member in the condition that the electroacoustic transducer has been mounted on the circuit board. Accordingly, if an electrical connection portion for soldering is disposed in the fixed bottom-side space, there is no need to dispose the electrical connection portion in the space at the rear of the diaphragm. Thus, the volume of the rear-side space of the diaphragm can be increased. As a result, the acoustic properties are improved by the reduction of the air damper effect.

Further, according to the present invention, there is provided an attachment structure of an electroacoustic transducer comprising: a diaphragm made of magnetic material; an electromagnetic coil for applying an oscillating magnetic field to the diaphragm; a housing member for containing the diaphragm and the electromagnetic coil; tapered coil spring terminals provided on a bottom surface of the housing member so as to abut against an external circuit board for obtaining electric connections therewith, respectively; and a compression quantity limiting member provided on the housing member so as to abut against the external circuit board for limiting a compression quantity of the spring terminals; wherein the attachment structure further comprises: a restricting member for restricting the housing member from a top surface thereof so as to bring the spring terminals into pressure contact with the external circuit board; and a buffer member interposed between the restricting member and the housing member.

According to the present invention, the buffer member is interposed between the housing member and the restricting member for restricting the housing member from the top thereof.
Accordingly, the condition that the compression quantity limiting member is in contact with the external circuit board can be kept so stable that the compression quantity of the spring terminals is also fixed. As a result, the contact pressure between each of the spring terminals and the external circuit board can be stabilized.

Further, according to the present invention, a spring modulus Kb of the buffer member is larger than a spring modulus Kt of the spring terminals.

According to the present invention, the spring modulus Kb of the buffer member is larger than the spring modulus Kt of each of the spring terminals. Accordingly, when the electroacoustic transducer is mounted on the external circuit board, the spring terminals begin to be compressed first, and the buffer member is not compressed and deformed unless the compression quantity limiting member abuts against the external circuit board. As a result, the pressure contact force of the spring terminals can be ensured stably.
Fig. 1A is a perspective view from the front side and Fig. 1B is a perspective view from the bottom side, both showing an embodiment of the present invention;
Fig. 2 is a plan view from the bottom side;
Fig. 3 is a sectional view taken on line A-A in Fig. 2;
Fig. 4 is a partially sectional view showing an attachment structure of an electroacoustic transducer according to the present invention;
Fig. 5 is a graph showing the spring properties of spring terminals and a buffer member; and
Fig. 6 is a partially sectional view showing an example of an attachment structure of a background-art electroacoustic transducer.

Now, a description will be given in more detail of preferred embodiments of the invention with reference to the accompanying drawings.

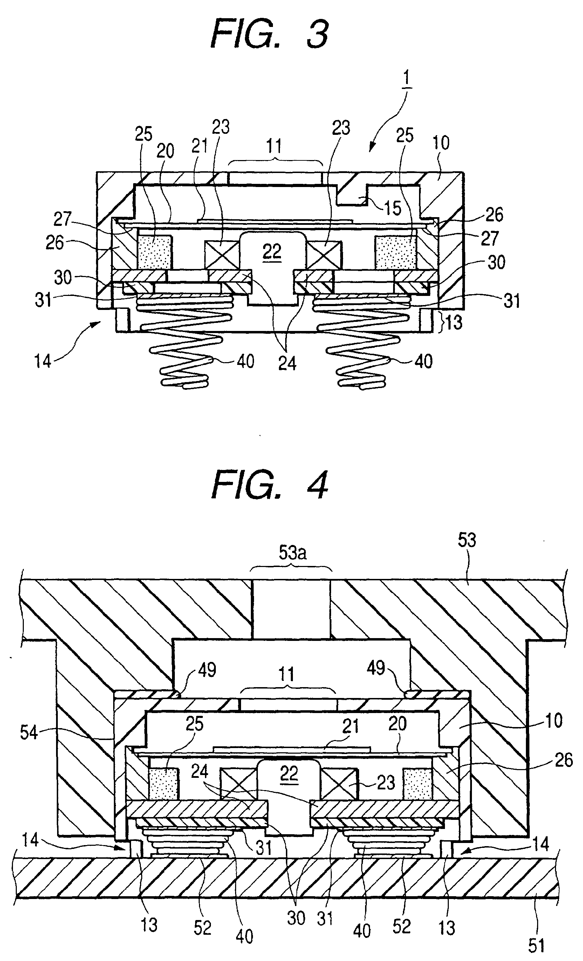

Figs . 1A and 1B show an embodiment of the present invention. Fig. 1A is a perspective view from the front side, and Fig. 1B is a perspective view from the bottom side. Fig. 2 is a plan view from the bottom side. Fig. 3 is a sectional view taken. on line A-A in Fig. 2.

An electroacoustic transducer 1 has a hollow columnar casing 10 constituting a housing member, and a base 24 also constituting a housing member. The base 24 is fitted into the casing 10 so as to form a columnar shape as a whole. For example, the columnar shape excluding projecting portions has dimensions of a diameter of about 9 mm and a height of about 3 mm.

The casing 10 is made of synthetic resin such as thermoplastic resin or the like. As shown in Fig. 1A, a sound release hole 11 is formed at the front center of the casing 10. A protrusion portion 12 for defining the direction of the transducer body is formed on the outer circumferential surface of the casing 10. A communication groove 14 is formed in the bottom portion of the outer circumferential surface of the casing 10 so as to make the inside communicate with the outside. The portion other than the communication groove 14 forms a skirt portion 13 which abuts against an external circuit board when the electroacoustic transducer 1 is mounted on the external circuit board.

A wiring board 30 is attached to the bottom surface of the base 24, which is filled with a resin mold 35 for fixing the base 24 and the wiring board 30 to the casing 10 as shown in Fig. 1B. Spring terminals 40 like tapered coils are fixed onto the wiring board 30.

The internal configuration of the transducer will be described. As shown in Fig. 3, a columnar magnetic core 22 is provided erectly at the center of the base 24, and a coil 23 is wound around the magnetic core 22. The base 24 and the magnetic core 22 are made of magnetic material and fixed to each other by caulking or the like. The base 24 and the magnetic core 22 may be integrated into a single pole piece member.

A magnet 25 is formed to be annular and disposed on the base 24 coaxially with the magnetic core 22 so as to ensure an annular internal space between the magnet 25 and the coil 23.

A support ring 26 is made of non-magnetic material and disposed on the base 24. The support ring 26 has an outer diameter a little smaller than the inner diameter of the casing 10. The upper surface of the support ring 26 abuts against the casing 10 so as to perform positioning of the base 24 in the direction of height. Annular steps are formed in the inner side of the upper surface of the support ring 26. A disc-like diaphragm 20 is horizontally mounted on a support step 27 which is one of the annular steps so that the diaphragm 20 is positioned in place.

The diaphragm 20 is made of magnetic material and supported by the step 27 of the support ring 26 at the circumferential edge portion of the support ring 26 so that a fixed air gap is ensured between the rear center of the diaphragm 20 and the forward end of the magnetic core 22. A disc-like magnetic piece 21 is fixed to the front center of the diaphragm 20 so as to increase the mass of the diaphragm 20. Thus, the efficiency of oscillation of the air is enhanced.

A plurality of protrusions 15 are formed circumferentially on the ceiling surface of the casing 10. The protrusions 15 keep a fixed air gap from the diaphragm 20 in the condition that the casing 10 has been attached. The protrusions 15 have a function to prevent the diaphragm 20 from coming off or being deformed when a strong impact is given to the transducer body. The protrusions 15 are high enough so as not to disturb normal oscillation of the diaphragm 20.

As shown in Fig. 2, on the wiring board 30 fitted to cover the base 24, arcuate conductor patterns 31 are formed correspondingly to the pair of spring terminals 40 respectively. A solder resist film is formed on each conductor pattern 31 so that only opposite end portions of the conductor pattern 31 are exposed but the rest portion thereof is coated with the solder resist film so as to be insulated. One of the exposed portions of each of the conductor patterns 31 forms an electric connection portion 32 for soldering a lead wire 23a or 23b of the coil 23. The other exposed portion of each of the conductor patterns 31 forms an electric connection portion 33 for soldering a root-side lead of the spring terminal 40. Thus, a coil conducting passageway is formed in the stated order of the spring terminal 40, the electric connection portion 33, the conductor pattern 31 and the electric connection portion.32.

Communication holes 34 are defined between the electric connection portions 32 and 33 respectively so as to penetrate the base 24 and the wiring board 30. A space at the rear of the diaphragm 20 communicates with a space below the bottom of the wiring board 30 through the communication holes 34, and further communicates with the outside through the communication groove 14 of the casing 10. One of the communication holes 34 forms a course in which the lead wires 23a and 23b are led out.

Outside the electric connection portions 32 and 33 and the communication holes 34, the resin mold 35 is charged into the casing 10 so as not to close the communication holes 34 and the communication groove 14. Thus, the base 24 and the wiring board 30 are fixed to the casing 10.

Next, a description will be given of a method for mounting the electroacoustic transducer 1.

Fig. 4 is a partially sectional view showing an attachment structure of the electroacoustic transducer according to the present invention. A receiving portion 54 for receiving the electroacoustic transducer 1 is formed inside a cover case 53 of an electronic apparatus. The casing 10 of the electroacoustic transducer 1 is subjected to positioning in the horizontal and height directions by substantial fitting between the casing 10 and the receiving portion 54.

A sound release aperture 53a is defined in the cover case 53 correspondingly to the position of the sound release hole 11 of the casing 10 so that sound generated by the electroacoustic transducer is released to the outside through the sound release hole 11 and the sound release aperture 53a. A space formed between the cover case 53 and the casing 10 is acoustically coupled with the space in front of the diaphragm 20 so as-to form an acoustic resonance space.

On the other hand, connection lands 52 are formed on a circuit board 51 of the electronic apparatus correspondingly to the spring terminals 40, respectively.

In a step of assembling the electronic apparatus, when the cover case 53 receiving the electroacoustic transducer 1 in advance is attached to the electronic apparatus body, the spring terminals 40 are brought into pressure contact with the connection lands 52 so that electric connections between the spring terminals 40 and the connection lands 52 are ensured, respectively. At this time, since the spring terminals 40 are formed into tapered coils, the forward ends of the tapered coils are received inside the root portions of the tapered coils respectively. As a result, the spring length when each of the spring terminals is compressed can be made shorter than a conventional cylindrical spring terminal. Thus, the height can be reduced when the electroacoustic transducer is mounted.

In addition, since the skirt portion 13 of the casing 10 abuts against the circuit board 51 under the condition that the electroacoustic transducer 1 is mounted, the spring terminals 40 are prevented from being compressed beyond necessity. Such a skirt portion 13 functions as a compression quantity limiting member for limiting the compression quantity of the spring terminals 40. Accordingly, even when the electroacoustic transducer 1 is mounted, the spring terminals 40 can absorb displacement in the direction where they are further compressed. It is therefore possible to prevent the contact pressure from varying.

In addition, a fixed space can be ensured below the bottom of the wiring board 30 by providing the skirt portion 13 so that the electric connection portions 32 and 33 for soldering can be disposed in the space below the bottom of the wiring board 30. As a result, it is not necessary to dispose such electric connection portions in the internal space of the transducer. Thus, the volume of the rear-side space of the diaphragm can be increased so that the air damper effect can be reduced.

Although here is shown an example in which the skirt portion 13 is formed integrally with the casing 10, the skirt portion 13 may be a separate member from the casing 10 and then attached to the casing 10, the wiring board 30 or the like.

Further, a buffer member 49 made of elastic material such as rubber is interposed between the upper surface of the casing 10 and the contact surface of the cover case 53. Thus, a gap between the skirt portion 13 and the circuit board 51 which is caused by the assembling tolerances of the cover case 53 and the circuit board 51, can be also absorbed by the deformation of the buffer member 49. As a result, the compression quantity of the spring terminals 40 is kept fixedly so that the contact pressure between the spring terminals 40 and the circuit board 51 and the electric properties can be stabilized.

In addition, the buffer member 49 seals the upper circumferential edge of the casing 10 so hermetically that sound in front of the diaphragm 20 is not leaked to the rear side of the diaphragm 20 through the gap between the casing 10 and the cover case 53. It is therefore possible to prevent interference between front sound and rear sound of the diaphragm 20.

Fig. 5 is a graph showing the spring property of each of the spring terminals 40 and the buffer member 49. The ordinate designates force f and the abscissa designates displacement x. When the electroacoustic transducer 1 which has been received in the cover case 53 is attached to the electronic apparatus body, each of the spring terminals 40 is first compressed with the spring property of f=Kt · x where the spring modulus of each of the spring terminals 40 is Kt.

When each of the spring terminals 40 is compressed to cause displacement x1, the skirt portion 13 abuts against the circuit board 51. If the buffer member 49 is not interposed on this occasion, the contact force would increase suddenly as shown by the broken line so that the spring terminals 40 would lose their springiness. Thus, there is a possibility that the casing 10 or the cover case 53 is subjected to excessive stress to be deformed, damaged, or so.

On the other hand, if the buffer member 49 is interposed, the buffer member 49 can be displaced with the spring property of f=Kb · x where the spring modulus of the buffer member 49 is Kb. Thus, the buffer member 49 can absorb a displacement or a variation in contact pressure. At this time, it is preferable that the spring modulus Kb of the buffer member 49 is larger than the spring modulus Kt of each of the spring terminals 40 so that the pressure contact force of the spring terminals 40 can be kept stable.

Next, a description will be given of the operation of the electroacoustic transducer 1. The magnet 25 is magnetized in the direction of thickness so that the bottom and the top of the magnet 25 are magnetized into N and S poles respectively by way of example. In this case, magnetic flux from the bottom of the magnet 25 passes through the circumferential edge portion of the base 24, the center portion of the base 24, the magnetic core 22, the center portion of the diaphragm 20, the circumferential edge portion of the diaphragm 20 and the top of the magnet 25, so that a closed magnetic circuit is formed as a whole . The magnet 25 has a function to apply a magnetostatic field to such a magnetic circuit. The diaphragm 20 is supported stably by this magnetostatic field in the condition that the diaphragm 20 is attracted toward the magnetic core 22 and the magnet 25.

When an electric oscillating signal is supplied through the lead wires 23a and 23b to the coil 23 which is wound around the magnetic core 22, the coil 23 applies an oscillating magnetic field to the magnetic circuit. Thus, the diaphragm 20 oscillates due to the superimposing of the oscillating magnetic field on the magnetostatic field so as to oscillate the air in front of and at the rear of the diaphragm 20.

The space in front of the diaphragm 20 functions as a resonance chamber. When the oscillation frequency of the diaphragm 20 substantially coincides with the resonance frequency of the resonance chamber, sound generated at a high sound pressure level is released to the external environment through the sound release hole 11 of the casing 10.

On the other hand, rear sound generated in the space at the rear of the diaphragm 20 reaches the space below the bottom of the wiring board 30. At this time, if the communication holes 34 were absent, the oscillation of the diaphragm 20 would be restrained by the air damper effect of the internal space of the transducer so that the sound pressure level would be lowered. As measures against such air damper effect, the communication holes 34 are provided in the base 24 and the wiring board 30. As a result, the volume of the space at the rear of the diaphragm 20 increases substantially so that the air damper effect can be reduced and the acoustic properties are improved.

Further, it is preferable that the communication groove 14 is formed in the casing 10 so as to make the space below the bottom of the wiring board 30 communicate with the outside. As a result, the air damper effect is further reduced, and the interference between front sound and rear sound of the diaphragm 20 can be eliminated to the utmost by the cover case 53. Thus, the sound pressure level of the sound can be kept high.

As described above, according to the present invention, spring terminals which are to abut against an external circuit board are shaped in the form of tapered coils so that the forward ends of the tapered coils enter the insides of the tapered coils in the condition that the spring terminals are compressed, respectively. Accordingly, the height at the time of mounting can be reduced, and the contact pressure between the spring terminals and the external circuit board can be stabilized.

In addition, a compression quantity limiting member is provided so as to abut against the external circuit board. When the spring terminals are compressed by a predetermined quantity, the spring terminals can absorb displacement in the direction in which the spring terminals are further compressed by the provision of the compression quantity limiting member, even in the condition that the electroacoustic transducer has been mounted on the external circuit board. Thus, the contact pressure can be prevented from varying.

Further, according to the present invention, the buffer member is interposed between the housing member and the restricting member for restricting the housing member from the top thereof. Accordingly, the condition that the compression quantity limiting member is in contact with the external circuit board can be kept stable. As a result, the contact pressure between each of the spring terminals and the external circuit board can be stabilized.

## Claims

1. An electroacoustic transducer comprising:
a diaphragm made of magnetic material;
an electromagnetic coil for applying an oscillating magnetic field to said diaphragm;
a housing member for containing said diaphragm and said electromagnetic coil;
tapered coil spring terminals provided on a bottom surface of said housing member so as to abut against an external circuit board for obtaining electric connections therewith, respectively; and
a compression quantity limiting member provided on said housing member so as to abut against said external circuit board for limiting a compression quantity of said spring terminals.

2. The electroacoustic transducer according to Claim 1, wherein a communication passageway for opening a space at a rear of said diaphragm is formed in the bottom surface of said housing member.

3. A transducer according to claim 1 or claim 2, wherein electric connection portions are disposed on the bottom surface of said housing member for soldering said spring terminals and lead wires of said electromagnetic coil, respectively.

4. An attachment structure for an electroacoustic transducer according to any of claims 1 to 3, the attachment structure comprising
a restricting member for restricting said housing member from a top surface thereof so as to bring said spring terminals into pressure contact with said external circuit board; and
a buffer member interposed between said restricting member and said housing member.

5. The attachment structure of an electroacoustic transducer according to claim 4, wherein a spring modulus Kb of said buffer member is larger than a spring modulus Kt of said spring terminals.

6. An attachment structure according to claim 4 or claim 5 in combination with an electroacoustic transducer of any of claims 1 to 3.
